# EUROPEAN PATENT APPLICATION

(11) **EP 2 535 393 A1**
(43) Date of publication of application: **19.12.2012**
(21) Application number: 10845500.7
(22) Date of filing: 12.02.2010
(51) Int. Cl.: C09K 11/80, C09K 11/79, C09K 11/81, H01L 33/00

(54) **BOROSILICATE LUMINESCENT MATERIAL AND PREPARING METHOD THEREOF**

(71) Applicant: Ocean's King Lighting Science&Technology Co., Ltd., Guangdong 518054 (CN)
(72) Inventor: ZHOU, Mingjie, Guangdong 518054 (CN); LI, Qingtao, Guangdong 518054 (CN); MA, Wenbo, Guangdong 518054 (CN)
(74) Representative: Johnson, Richard Alan
(86) International application number: PCT/CN2010/070683
(87) International publication number: WO 2011/097826

(57) **Abstract**

Provided are a borosilicate luminescent material and a preparing method for making the material. The borosilicate luminescent material has a chemical formula of aM₂O·bLn₂O₃·cAl₂O₃·dR₂O₃·eSiO₂·fCeO₂·gTb₂O₃, wherein, M is alkaline earth metal or alkali metal, Ln is one or two elements selected from the group consisting of yttrium and gadolinium, R is one or two elements selected from the group consisting of boron and phosphorus, the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5. The preparing methods comprises the following steps: 1 ) providing the compounds used as the sources of the above elements; 2 ) mixing and grinding the compounds to get a mixture; 3 ) pre-sintering the mixture and then grinding the mixture to get a pre-sintered matter; 4 ) sintering the pre-sintered matter in reducing atmosphere and then cooling the sintered matter to get the borosilicate luminescent material.

## Description

### FIELD OF THE INVENTION

The present disclosure relates to luminescent materials, especially to a borosilicate luminescent material and a preparation method for making the material.

### BACKGROUND OF THE INVENTION

Recently, Light Emitting Diode (LED) has become a new light source. Commonly, a white light LED can be obtained by the following methods: 1. blue light LED coordinating with yellow fluorescence powder; 2. encapsulating chips of different chromatic lights, in which different chromatic lights composite to produce a white light; and 3. ultraviolet LED exciting tricolor fluorescence powders to produce a white light.

White light LED produced by blue light LED coordinating with yellow fluorescence powder has a low color rendering index. This is because the white light LED mainly contains blue light and lacks of red light (which presents a negative color). White light LED produced by encapsulating chips of different chromatic lights cannot be widely used for the drive circuits of the chips are complex. White light LED produced by ultraviolet LED exciting tricolor fluorescence powders has a high color rendering index. Green fluorescence powder, such as sulfide fluorescence material, is an effective tricolor fluorescence powder. However, the sulfide fluorescence material is chemically unstable, which affects the useful lifespan of the LED light source.

### SUMMARY OF THE INVENTION

The technical problem of the present invention to be solved is to provide a borosilicate luminescent material which can be simply prepared, have excellent quality, low cost, and can be broadly applied, and a preparation method for making the borosilicate luminescent material.

The technical solution to solve the technical problem in the present invention is: providing a borosilicate luminescent material, the material has a chemical formula of aM₂O·bLn₂O₃·cAl₂O₃·dR₂O₃·eSiO₂·CeO₂·gTb₂O₃, wherein, M is alkaline earth metal or alkali metal, Ln is one or two elements selected from the group consisting of elements yttrium (Y) and gadolinium (Gd), R is one or two elements selected from the group consisting of elements boron (B) and phosphorus (P), the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5.

And, a preparation method for making a borosilicate luminescent material comprises the following steps:

Step one, providing the compounds used as a source of M⁺, the compounds used as a source of Ln³⁺, the compounds used as a source of Al³⁺, the compounds used as a source of R³⁺, the compounds used as a source of silicon, the compounds used as a source of Ce³⁺, and the compounds used as a source of Tb³⁺ according to a molar ratio of the elements in "aM₂O·bLn₂O₃·cAl₂O₃·dR₂O₃·eSiO₂·fCeO₂·gTb₂O₃", wherein, the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5; M is alkaline earth metal or alkali metal, Ln is one or two elements selected from the group consisting of Y and Gd, R is one or two elements selected from the group consisting of B and P;

Step two, mixing and grinding the compounds to get a mixture;

Step three, pre-sintering the mixture and then grinding the mixture to get a pre-sintered matter;

Step four, sintering the pre-sintered matter in reducing atmosphere and then cooling the sintered matter to get the borosilicate luminescent material.

In the preparation method of the present invention, the compounds used as a source of M⁺ is one or more ingredients selected from the group consisting of carbonate of M⁺, nitrate of M⁺, and oxalate of M⁺. The compounds used as a source of Ln³⁺ is one or more ingredients selected from the group consisting of carbonate of Ln³⁺ nitrate of Ln³⁺, and oxalate of Ln³⁺. The compounds used as a source of Al³⁺ is one or more ingredients selected from the group consisting of carbonate of Al³⁺, nitrate of Al³⁺, and oxalate of Al³⁺. The compounds used as a source of Ce³⁺ is one or more ingredients selected from the group consisting of carbonate of Ce³⁺ nitrate of Ce³⁺, and oxalate of Ce³⁺. The compounds used as a source of Tb³⁺ is one or more ingredients selected from the group consisting of carbonate of Tb³⁺, nitrate of Tb³⁺, and oxalate of Tb³⁺. The compounds used as a source of silicon is silicon dioxide. The compounds used as a source of R³⁺ is boric acid or phosphate.

In step three of the preparation method of the present invention, the pre-sintering process is carried out in atmosphere at 850 °C to 950 °C for 2 hours to 8 hours.

In step four of the preparation method of the present invention, the sintering process is carried out in reducing atmosphere at 750 °C to 880 °C for 2 hours to 6 hours.

The reducing atmosphere includes hydrogen (H₂), a mixture of nitride (N₂) and H₂, and powdered carbon.

In the preparation method of the present invention, the alkaline earth metal M is at least one of calcium (Ca), strontium (Sr), and barium (Ba).

In the preparation method of the present invention, the alkali metal M is at least one of lithium (Li), sodium (Na), and potassium (K).

In the preparation method of the present invention, the a, b, c, d, e, f, and g have optimal values of: 8≤a≤15, 5≤b≤10, 23≤c≤28, 35≤d≤40, 0≤e≤10, 0.05≤f≤0.8, and 0.2≤g≤1.

The borosilicate luminescent material of the present invention contains Ce ion and Tb ion which can transit energy effectively to each other nonradiatively, that is, when one of the luminescence center is excited, the exciting energy of one location of the illuminant transits to another location of the illuminant, or the exciting energy of the luminescence center transits to another luminescence center, with which the luminescence intensity of the borosilicate luminescent material is greatly enhanced, and, the borosilicate luminescent material is chemically stable, and has an effective photoluminescence. Especially, exited by the 350 nm to 370 nm light, the borosilicate luminescent material has a stronger luminescence intensity than that of the commercial fluorescent powders such as LaPO₄:Ce Tb, and ZnS:Cu under their optimal exciting conditions. The preparation method for making the borosilicate luminescent material of the present invention includes a pre-sintering process in atmosphere and a sintering process in reducing atmosphere, which allows the rare-earth element contained in the borosilicate luminescent material to diffuse therein, and larger crystals formed in the borosilicate luminescent material.

### BRIEF DESCRIPTION OF THE DRAWINGS

Further description of the present invention will be illustrated, which combined with drawings and embodiments in the drawings.

FIG.1 shows an emission spectrum of the borosilicate luminescent material of example 1, and emission spectrums of the commercial fluorescent powders LaPO₄:Ce, Tb, and ZnS:Cu;

FIG. 2 shows an excitation spectrum and an emission spectrum of the borosilicate luminescent material of example 2;

FIG. 3 shows an excitation spectrum and an emission spectrum of the borosilicate luminescent material of example 3;

FIG. 4 shows an excitation spectrum and an emission spectrum of the borosilicate luminescent material of example 7;

FIG. 5 shows a flow chat of preparation method of the borosilicate luminescent material.

### DETAILED DESCRIPTION OF ILLUSTRATED EMBODIMENTS

The examples hereinafter described merely being preferred or of the disclosure. It will be apparent that various changes may be made thereto without departing from the spirit and scope of the disclosure.

The present invention provides a borosilicate luminescent material, the borosilicate luminescent material has a chemical formula of aM₂O·bLn₂O₃·cAl₂O₃·dR₂O₃·eSiO₂·fCeO₂·gTb₂O₃, wherein, M is alkaline earth metal or alkali metal, Ln is one or two elements selected from the group consisting of Y and Gd, R is one or two elements selected from the group consisting of B and P; the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5.

The alkali metal M is one or more ingredients selected from the group consisting of Li, Na, and K. The alkaline earth metal M is one or more ingredients selected from the group consisting of Ca, Sr, and Ba. To obtain a much stronger green light, the a, b, c, d, e, f, and g have optimal values of: 8≤a≤15, 5≤b≤10, 23≤c≤28, 35≤d≤40, 0≤e≤10, 0.05≤f≤0.8, and 0.2≤g≤1.

The borosilicate luminescent material of the present invention contains Ce³⁺ and Tb³⁺ which can transit energy effectively to each other nonradiatively, that is, when one of the luminescence center is excited, the exciting energy of one location of the illuminant transits to another location of the illuminant, or the exciting energy of the luminescence center transits to another luminescence center, as such the luminescent material having high luminescence intensity is obtained. The borosilicate luminescent material of the present invention is chemically stable, and has an effective photoluminescence. Especially, exited by the 350 nm to 370 nm light, the borosilicate luminescent material has a stronger luminescence intensity than that of the commercial fluorescent powders such as LaPO₄:Ce Tb, and ZnS:Cu under their optimal exciting conditions.

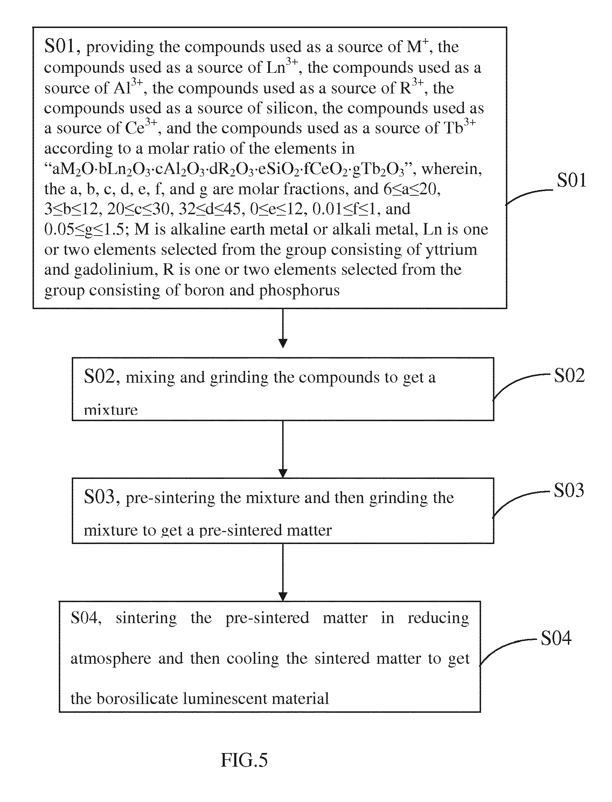

Referring to FIG. 5, a preparation method for making the borosilicate luminescent material includes the following steps.

S01, the compounds used as a source of M⁺, the compounds used as a source of Ln³⁺, the compounds used as a source of Al³⁺, the compounds used as a source of R³⁺, the compounds used as a source of silicon, the compounds used as a source of Ce³⁺, and the compounds used as a source of Tb³⁺ are provided according to a molar ratio of the elements in "aM₂O·bLn₂O₃·cAl₂O₃·dR₂O₃·eSiO₂-fCeO₂·gTb₂O₃", wherein, the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5; M is alkaline earth metal or alkali metal, Ln is one or two elements selected from the group consisting of Y and Gd, R is one or two elements selected from the group consisting of B and P.

S02, mixing and grinding the compounds to get a mixture.

S03, pre-sintering the mixture and then grinding the mixture to get a pre-sintered matter.

S04, sintering the pre-sintered matter in reducing atmosphere and then cooling the sintered matter to get the borosilicate luminescent material.

In step S01, the compounds used as a source of M⁺ is one or more ingredients selected from the group consisting of carbonate of M⁺, nitrate of M⁺, and oxalate of M⁺. The compounds used as a source of Ln³⁺ is one or more ingredients selected from the group consisting of carbonate of Ln³⁺, nitrate of Ln³⁺, and oxalate of Ln³⁺. The compounds used as a source of Al³⁺ is one or more ingredients selected from the group consisting of carbonate of Al³⁺, nitrate of Al³⁺, and oxalate of Al³⁺. The compounds used as a source of Ce³⁺ is one or more ingredients selected from the group consisting of carbonate of Ce³⁺, nitrate of Ce³⁺, and oxalate of Ce³⁺. The compounds used as a source of Tb³⁺ is one or more ingredients selected from the group consisting of carbonate of Tb³⁺, nitrate of Tb³⁺, and oxalate of Tb³⁺. The compounds used as a source of silicon is silicon dioxide. The compounds used as a source of R³⁺ is boric acid or phosphate.

In step S03, the pre-sintering process is carried out in atmosphere at 850 °C to 950 °C for 2 hours to 8 hours.

In step S04, the sintering process is carried out in reducing atmosphere (the reducing atmosphere includes hydrogen (H₂), a mixture of nitride (N₂) and H₂, or powdered carbon) at 750 °C to 880 °C for 2 hours to 6 hours according to capacity of the oven, weight of material, material kinds, and different formulations. The sintered matter is then cooled to get the borosilicate luminescent material.

The preparation method of the present invention includes a pre-sintering process in atmosphere and a sintering process in reducing atmosphere, which allows the rare-earth element contained in the borosilicate luminescent material to diffuse therein, and larger crystals formed in the borosilicate luminescent material. The matrix of the borosilicate luminescent material can absorb energy and can effectively transit the energy to the rare-earth elements of the borosilicate luminescent material, the rare-earth elements that obtained the energy sensitize to enhance the luminescence intensity of the borosilicate luminescent material.

Special examples are disclosed as follows to demonstrate the borosilicate luminescent materials and preparation methods of the borosilicate luminescent materials.

EXAMPLE 1

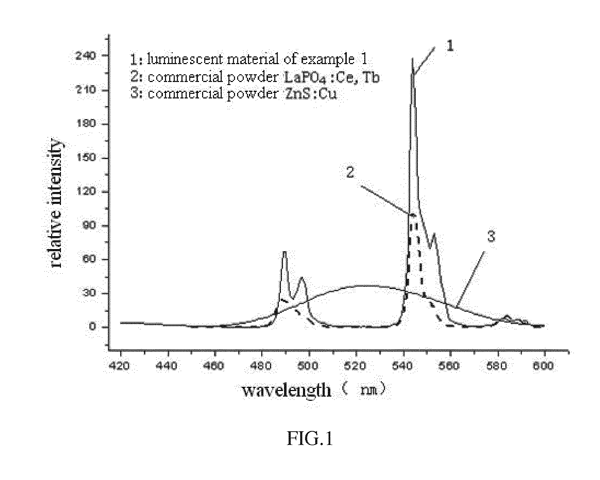

5.54 gram (g) lithium carbonate, 8.75 g yttrium oxide, 13.39 g aluminum oxide, 24.8 g boric acid, 3 g silicon dioxide, 0.43 g cerium oxide, and 1.869 g terbium oxide are provided and ball grinded for 30 minutes (min). The grinded matter is pre-sintered in atmosphere at 930 °C for 6 hours and then grinded again. After that, a sintering process is carried out in reducing atmosphere of a mixture of N₂ and H₂ to 820 °C and kept for 6 hours. As such, a green borosilicate luminescent powder material having a chemical formula of 15Li₂O·7.75Y₂O₃·26.25Al₂O₃·40B₂O₃·10SiO₂·0.5CeO₂·1Tb₂O₃ is obtained. Referring to FIG. 1, curve 1 is an emission spectrum of the 15Li₂O·7.75Y₂O₃·26.25Al₂O₃·40B₂O₃·10SiO₂·0.5CeO₂.1Tb₂O₃, curve 2 is an emission spectrum of the commercial powder LaPO₄:Ce,Tb, and curve 3 is an emission spectrum of the commercial powder ZnS:Cu. Fig. 1 indicates that the 15Li₂O·7.75Y₂O₃·26.25Al₂O₃·40B₂O₃·10SiO₂·0.5CeO₂.1Tb₂O₃ has a stronger luminescence intensity than that of the commercial powders. The equipment for testing the spectrums includes a fluorescence spectrophotometer (produced by Dao-Jin company, type: RF-5301PC). The test is carried out under a condition of: low sensitivity, and 1.5 nm slit.

EXAMPLE 2

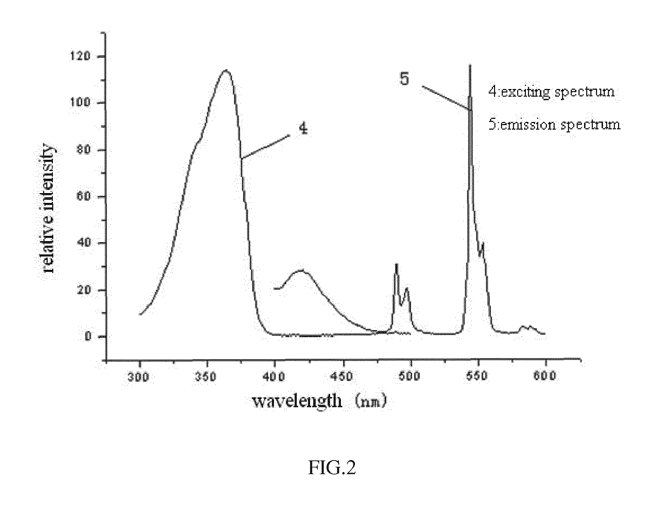

7.95 g sodium carbonate, 8.75 g yttrium oxide, 13.39 g aluminum oxide, 24.8 g boric acid, 3 g silicon dioxide, 0.043 g cerium oxide, and 1.4954 g terbium oxide are provided and ball grinded for 30 min. The grinded matter is pre-sintered in atmosphere at 900 °C and then grinded again. After that, a sintering process is carried out in reducing atmosphere of a mixture of N₂ and H₂ to 880 °C and kept for 4 hours. As such, a green borosilicate luminescent powder material having a chemical formula of 15Na₂O·7.75Y₂O₃·26.25Al₂O₃·40B₂O₃-10SiO₂·0.05CeO₂·0.8Tb₂O₃ is obtained. The luminescent material of example 2 can be excided by 363 nm light to emit blue-green light. Referring to FIG. 2, curve 4 is an exciting spectrum of the 15Na₂O·7.75Y₂O₃-26.25Al₂O₃·40B₂O₃·10SiO₂·0.05CeO₂·0.8Tb₂O₃, curve 5 is an emission spectrum of the 15Na₂O·7.75Y₂O₃·26.25Al₂O₃·40B₂O₃·10SiO₂·0.05CeO₂·0.8Tb₂O₃. The equipment for testing the spectrums includes a fluorescence spectrophotometer (produced by Dao-Jin company, type: RF-5301PC). The test is carried out under a condition of: low sensitivity, and 1.5 nm slit.

EXAMPLE 3

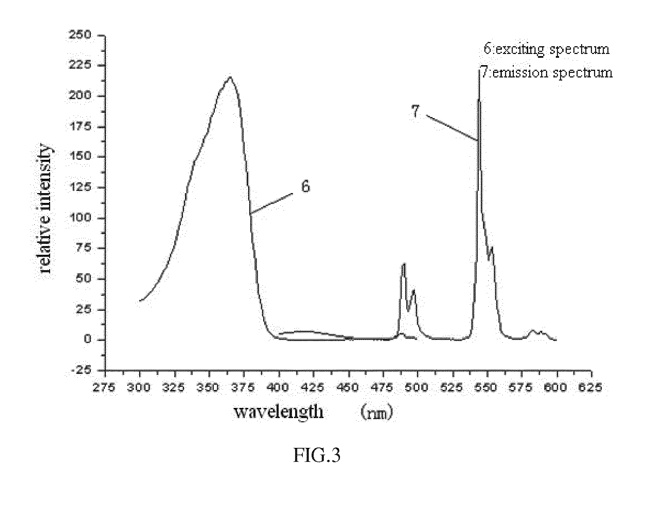

7.95 g sodium carbonate, 8.75 g yttrium oxide, 13.39 g aluminum oxide, 24.8 g boric acid, 3 g silicon dioxide, 0.43 g cerium oxide, and 1.6823 g terbium oxide are provided and ball grinded for 30 min. The grinded matter is pre-sintered in atmosphere at 920 °C and then grinded again. After that, a sintering process is carried out in reducing atmosphere of H₂ to 800 °C and kept for 2 hours. As such, a green borosilicate luminescent powder material having a chemical formula of 15Na₂O·7.75Y₂O₃·26.25Al₂O₃·40B₂O₃·10SiO₂·0.5CeO₂·0.9Tb₂O₃ is obtained. The luminescent material of example 3 can be excided by 363 nm light to emit blue-green light. Referring to FIG. 3, curve 6 is an exciting spectrum of the 15Na₂O·7.75Y₂O₃·26.25Al₂O₃·40B₂O₃·10SiO₂·0.5CeO₂·0.9Tb₂O₃, curve 7 is an emission spectrum of the 15Na₂O·7.75Y₂O₃·26.25Al₂O₃·40B₂O₃·10SiO₂-0.5CeO₂·0.9Tb₂O₃. The equipment for testing the spectrums includes a fluorescence spectrophotometer (produced by Dao-Jin company, type: RF-5301PC). The test is carried out under a condition of: low sensitivity, and 1.5 nm slit.

EXAMPLE 4

3.18 g sodium carbonate, 21.75 g yttrium oxide, 15.3 g aluminum oxide, 27.9 g boric acid, 2.1 g silicon dioxide, 0.86 g cerium oxide, and 2.804 g terbium oxide are provided and ball grinded for 30 min. The grinded matter is pre-sintered in atmosphere at 880 °C for 8 hours and then grinded again. After that, a sintering process is carried out in reducing atmosphere of powdered carbon to 750 °C and kept for 6 hours. As such, a green borosilicate luminescent powder material having a chemical formula of 6Na₂O-7.75Gd₂O₃·30Al₂O₃·45B₂O₃·7SiO₂·1CeO₂-1.5Tb₂O₃ is obtained.

EXAMPLE 5

16.62 g potassium oxalate, 13.78 g yttrium nitrate, 42.6 g aluminum nitrate, 27.9 g boric acid, 3 g silicon dioxide, 0.0115 g cerium carbonate, and 0.1245 g terbium carbonate are provided and ball grinded for 30 min. The grinded matter is pre-sintered in atmosphere at 900 °C for 8 hours and then grinded again. After that, a sintering process is carried out in reducing atmosphere of powered carbon to 800 °C and kept for 5 hours. As such, a green borosilicate luminescent powder material having a chemical formula of 6K₂O·5Y₂O₃·20Al₂O₃·45B₂O₃·10SiO₂-0.01CeO₂·0.05Tb₂O₃ is obtained.

EXAMPLE 6

17 g sodium nitrate, 5.36 g yttrium carbonate, 23.4 g aluminum carbonate, 31.95 g phosphorous pentoxide, 3.6 g silicon dioxide, 1.304 g cerium nitrate, and 2.5875 g terbium nitrate are provided and ball grinded for 30 min. The grinded matter is pre-sintered in atmosphere at 850 °C for 8 hours and then grinded again. After that, a sintering process is carried out in reducing atmosphere of a mixture of N₂ and H₂ to 750 °C and kept for 4 hours. As such, a green borosilicate luminescent powder material having a chemical formula of 20Na₂O·3Y₂O₃·20Al₂O₃·45P₂O₃·12SiO₂·0.8CeO₂·1.5Tb₂O₃ is obtained.

EXAMPLE 7

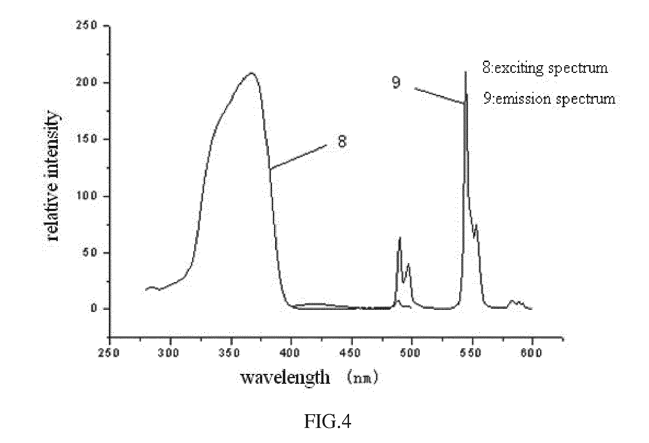

6.17 g lithium carbonate, 9.709 g yttrium oxide, 14.892 g aluminum oxide, 26.64 g boric acid, 0.473 g cerium oxide, and 2.056 g terbium oxide are provided and ball grinded for 30 min. The grinded matter is pre-sintered in atmosphere at 930 °C for 4 hours and then grinded again. After that, a sintering process is carried out in reducing atmosphere of a mixture of N₂ and H₂ to 790 °C and kept for 2 hours. As such, a green borosilicate luminescent powder material having a chemical formula of 16.7Li₂O·8.6Y₂O₃·29.2Al₂O₃·44.4B₂O₃·0.55CeO₂·1.1Tb₂O₃ is obtained. The luminescent material of example 7 can be excided by 367 nm light to emit blue-green light. Referring to FIG. 4, curve 8 is an exciting spectrum of the 16.7Li₂O·8.6Y₂O₃·29.2Al₂O₃·44.4B₂O₃·0.55CeO₂·1.1Tb₂O₃, curve 9 is an emission spectrum of the 16.7Li₂O.8.6Y₂O₃·29.2Al₂O₃·44.4B₂O₃·0.55CeO₂·1.1Tb₂O₃. The equipment for testing the spectrums includes a fluorescence spectrophotometer (produced by Dao-Jin company, type: RF-5301PC). The test is carried out under a condition of: low sensitivity, and 1.5 nm slit.

EXAMPLE 8

11.07 g strontium carbonate, 17.13 g yttrium oxalate, 41.73 g aluminum oxalate, 28.4 g phosphorous pentoxide, 3 g silicon dioxide, 0.6804 g cerium oxalate, and 2.91 g terbium oxalate are provided and ball grinded for 30 min. The grinded matter is pre-sintered in atmosphere at 850 °C for 8 hours and then grinded again. After that, a sintering process is carried out in reducing atmosphere of a mixture of N₂ and H₂ to 760 °C and kept for 4 hours. As such, a green borosilicate luminescent powder material having a chemical formula of 15SrO·7.75Y₂O₃·26.25Al₂O₃·40P₂O₃·10SiO₂·0.5CeO₂·1Tb₂O₃ is obtained.

EXAMPLE 9

15.87 g strontium nitrate, 19.16 g gadolinium carbonate, 30.7g aluminum carbonate, 28.4 g phosphorous pentoxide, 3 g silicon dioxide, 0.92 g cerium carbonate, and 2.987 g terbium carbonate are provided and ball grinded for 30 min. The grinded matter is pre-sintered in atmosphere at 850 °C for 8 hours and then grinded again. After that, a sintering process is carried out in reducing atmosphere of H₂ to 780 °C and kept for 6 hours. As such, a green borosilicate luminescent powder material having a chemical formula of 15SrO·7.75Gd₂O₃·26.25Al₂O₃·40P₂O₃·10SiO₂·0.8CeO₂·1.2Tb₂O₃ is obtained.

EXAMPLE 10

10.2 g lithium oxalate, 13.78 g yttrium nitrate, 23.4 g aluminum carbonate, 31.95 g phosphorous pentoxide, 3 g silicon dioxide, 0.086 g cerium oxide , and 1.308 g terbium oxide are provided and ball grinded for 30 min. The grinded matter is pre-sintered in atmosphere at 850 °C for 8 hours and then grinded again. After that, a sintering process is carried out in reducing atmosphere of H₂ to 780 °C and kept for 8 hours. As such, a green borosilicate luminescent powder material having a chemical formula of 20Li₂O·5Y₂O₃·20Al₂O₃·45P₂O₃·10SiO₂·0.1CeO₂·0.7Tb₂O₃ is obtained.

EXAMPLE 11

12.3 g calcium nitrate, 22.42 g gadolinium oxalate, 41.74 g aluminum oxalate, 24.8 g boric acid, 3 g silicon dioxide, 1.63 g cerium nitrate, and 1.869 g terbium oxide are provided and ball grinded for 30 min. The grinded matter is pre-sintered in atmosphere at 880 °C for 6 hours and then grinded again. After that, a sintering process is carried out in reducing atmosphere of H₂ to 780 °C and kept for 7 hours. As such, a green borosilicate luminescent powder material having a chemical formula of 15CaO·7.75Gd₂O₃·26.25Al₂O₃-40B₂O₃-10SiO₂-CeO₂·1Tb₂O₃ is obtained.

EXAMPLE 12

20.277 g barium oxalate, 14.312 g yttrium carbonate, 34.98 g aluminum oxalate, 24.8 g boric acid, 3 g silicon dioxide, 1.035 g cerium carbonate, and 2.803 g terbium oxide are provided and ball grinded for 30 min. The grinded matter is pre-sintered in atmosphere at 880 °C for 8 hours and then grinded again. After that, a sintering process is carried out in reducing atmosphere of H₂ to 780 °C and kept for 6 hours. As such, a green borosilicate luminescent powder material having a chemical formula of 18BaO·8Y₂O₃·22Al₂O₃·40B₂O₃·10SiO₂·0.9CeO₂·1.5Tb₂O₃ is obtained.

EXAMPLE 13

12.8 g calcium oxalate, 29.67 g gadolinium carbonate, 59.64 g aluminum nitrate, 24.8 g boric acid, 0.688 g cerium oxide, and 2.43 g terbium oxide are provided and ball grinded for 30 min. The grinded matter is pre-sintered in atmosphere at 850 °C for 8 hours and then grinded again. After that, a sintering process is carried out in reducing atmosphere of a mixture of N₂ and H₂ to 800 °C and kept for 6 hours. As such, a green borosilicate luminescent powder material having a chemical formula of 20CaO·12Gd₂O₃·28Al₂O₃40B₂O₃·0.8CeO₂·1.3Tb₂O₃ is obtained.

EXAMPLE 14

7.5 g calcium carbonate, 14.05 g gadolinium oxide, 13.39 g aluminum oxide, 28.4 g phosphorous pentoxide, 3 g silicon dioxide, 0.258 g cerium oxide, and 1.869 g terbium oxide are provided and ball grinded for 30 min. The grinded matter is pre-sintered in atmosphere at 850 °C for 8 hours and then grinded again. After that, a sintering process is carried out in reducing atmosphere of a mixture of N₂ and H₂ to 760 °C and kept for 6 hours. As such, a green borosilicate luminescent powder material having a chemical formula of 15CaO·7.75Gd₂O₃·26.25Al₂O₃·40P₂O₃·10SiO₂·0.3CeO₂-1Tb₂O₃ is obtained.

EXAMPLE 15

11.1 g sodium oxalate, 12.36 g gadolinium carbonate, 10.2 g aluminum oxide, 27.9 g boric acid, 3 g silicon dioxide, 0.086 g cerium oxide, and 1.75 g terbium carbonate are provided and ball grinded for 30 min. The grinded matter is pre-sintered in atmosphere at 850 °C for 8 hours and then grinded again. After that, a sintering process is carried out in reducing atmosphere of H₂ to 780 °C and kept for 6 hours. As such, a borosilicate luminescent material having a chemical formula of 20Na₂O·5Gd₂O₃·20Al₂O₃·45B₂O₃·10SiO₂·0.1CeO₂-0.7Tb₂O₃ is obtained.

EXAMPLE 16

15.15 g potassium nitrate, 19.16 g gadolinium carbonate, 13.39 g aluminum oxide, 24.8 g boric acid, 3 g silicon dioxide, 0.258 g cerium oxide, and 2.485 g terbium carbonate are provided and ball grinded for 30 min. The grinded matter is pre-sintered in atmosphere at 850 °C for 8 hours and then grinded again. After that, a sintering process is carried out in reducing atmosphere of H₂ to 750 °C and kept for 6 hours. As such, a green borosilicate luminescent powder material having a chemical formula of 15K₂O·7.75Gd₂O₃·26.25Al₂O₃·40B₂O₃·10SiO₂-0.3CeO₂·1Tb₂O₃ is obtained.

It is believed that the present invention and its advantages will be understood from the foregoing description, and it will be apparent that various changes may be made thereto without departing from the spirit and scope of the disclosure or sacrificing all of its advantages, the examples hereinbefore described merely being preferred or present invention of the disclosure.

## Claims

1. A borosilicate luminescent material, which has a chemical formula of aM₂O·bLn₂O₃·cAl₂O₃·dR₂O₃-eSiO₂-fCeO₂·gTb₂O₃, wherein, M is alkaline earth metal or alkali metal, Ln is one or two elements selected from the group consisting of yttrium and gadolinium, R is one or two elements selected from the group consisting of boron and phosphorus, the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5.

2. The borosilicate luminescent material according to claim 1, wherein said alkali metal M is one or more ingredients selected from the group consisting of lithium, sodium, and potassium.

3. The borosilicate luminescent materials according to claim 1, wherein said alkaline earth metal M is one or more ingredients selected from the group consisting of calcium, strontium, and barium.

4. The borosilicate luminescent materials according to claim 1, wherein the a, b, c, d, e, f, and g have values of: 8≤a≤15, 5≤b≤10, 23≤c≤28, 35≤d≤40, 0≤e≤10, 0.05≤f≤0.8, and 0.2≤g≤1.

5. A preparation method for making a borosilicate luminescent material, comprising the following steps of:
Step one, providing the compounds used as a source of M⁺, the compounds used as a source of Ln³⁺, the compounds used as a source of Al³⁺, the compounds used as a source of R³⁺ the compounds used as a source of silicon, the compounds used as a source of Ce³⁺, and the compounds used as a source of Tb³⁺ according to a molar ratio of the elements in "aM₂O·bLn₂O₃·cAl₂O₃·dR₂O₃·eSiO₂·fCeO₂·gTb₂O₃", wherein, the a, b, c, d, e, f, and g are molar fractions, and 6≤a≤20, 3≤b≤12, 20≤c≤30, 32≤d≤45, 0≤e≤12, 0.01≤f≤1, and 0.05≤g≤1.5; M is alkaline earth metal or alkali metal, Ln is one or two elements selected from the group consisting of yttrium and gadolinium, R is one or two elements selected from the group consisting of boron and phosphorus;
Step two, mixing and grinding the compounds to get a mixture;
Step three, pre-sintering the mixture and then grinding the mixture to get a pre-sintered matter;
Step four, sintering the pre-sintered matter in reducing atmosphere and then cooling the sintered matter to get the borosilicate luminescent material.

6. The preparation method for making a borosilicate luminescent material according to claim 5, wherein the compounds used as a source of M⁺ is one or more ingredients selected from the group consisting of carbonate of M⁺, nitrate of M⁺, and oxalate of M⁺, the compounds used as a source of Ln³⁺ is one or more ingredients selected from the group consisting of carbonate of Ln³⁺, nitrate of Ln³⁺, and oxalate of Ln³⁺, the compounds used as a source of Al³⁺ is one or more ingredients selected from the group consisting of carbonate of Al³⁺, nitrate of Al³⁺, and oxalate of Al³⁺, the compounds used as a source of Ce³⁺ is one or more ingredients selected from the group consisting of carbonate of Ce³⁺, nitrate of Ce³⁺, and oxalate of Ce³⁺, the compounds used as a source of Tb³⁺ is one or more ingredients selected from the group consisting of carbonate of Tb ³⁺, nitrate of Tb³⁺, and oxalate of Tb³⁺, the compounds used as a source of silicon is silicon dioxide, the compounds used as a source of R³⁺ is boric acid or phosphate.

7. The preparation method for making a borosilicate luminescent material according to claim 5, wherein in step three, the pre-sintering process is carried out in atmosphere at 850 °C to 950 °C for 2 hours to 8 hours.

8. The preparation method for making a borosilicate luminescent material according to claim 5, wherein in step four, the sintering process is carried out in reducing atmosphere at 750 °C to 880 °C for 2 hours to 6 hours.

9. The preparation method for making a borosilicate luminescent material according to claim 8, wherein the reducing atmosphere is hydrogen, carbon monoxide, or a mixture of nitride and hydrogen.

10. The preparation method for making a borosilicate luminescent material according to claim 5, wherein said alkaline earth metal M is at least one of calcium, strontium, and barium.

11. The preparation method for making a borosilicate luminescent material according to claim 5, wherein said alkali metal M is at least one of lithium, sodium, and potassium.

12. The preparation methods for making a borosilicate luminescent material according to claim 5, wherein the a, b, c, d, e, f, and g have values of: 8≤a≤15, 5≤b≤10, 23≤c≤28, 35≤d≤40, 0≤e≤10, 0.05≤f≤0.8, and 0.2≤g≤1.
